# EUROPEAN PATENT APPLICATION

(11) **EP 2 423 348 A1**
(43) Date of publication of application: **29.02.2012**
(21) Application number: 10767061.4
(22) Date of filing: 20.04.2010
(51) Int. Cl.: C23C 14/24, H01M 4/1395

(54) **VACUUM DEPOSITION SYSTEM AND VACUUM DEPOSITION METHOD**

(30) Priority: 21.04.2009 JP 2009103431
(71) Applicant: Ulvac, Inc., Chigasaki-shi Kanagawa 253-8543 (JP)
(72) Inventor: SHIMADA, Tetsuya, Chigasaki-shi Kanagawa 253-8543 (JP); HIDA, Masanori, Chigasaki-shi Kanagawa 253-8543 (JP); ODAGI, Hideyuki, Chigasaki-shi Kanagawa 253-8543 (JP); MIKAMI, Shun, Chigasaki-shi Kanagawa 253-8543 (JP); AODAI, Makoto, Tsukuba-shi Ibaraki 300-2635 (JP); KURAUCHI Toshiharu, Tsukuba-shi Ibaraki 300-2635 (JP)
(74) Representative: Körber, Martin Hans
(86) International application number: PCT/JP2010/057011
(87) International publication number: WO 2010/123004

(57) **Abstract**

The present invention aims to provide a technology which uses an apparatus having a simple configuration to efficiently form a film with uniform film thickness and film properties, when continuously forming a film using highly reactive lithium by vacuum deposition. The present invention is a vacuum deposition system comprising a vacuum deposition chamber 2 wherein an evaporation material 10 is deposited on a substrate 50 by deposition, a substrate supplying/replacing system 3 connected to the vacuum deposition chamber 2 for performing supplying and replacing the substrate 50 to and from the vacuum deposition chamber 2, and a material supplying/replacing system 4 connected to the vacuum deposition chamber 2 for performing supplying and replacing the evaporation material 10 to and from the vacuum deposition chamber 2. The material supplying/replacing system 4 is provided with a material loading chamber 45 in which the evaporation material 10 is disposed in an evaporation container 7 in an atmosphere that is blocked off to ambient air and a material replacing chamber 43 in which the evaporation container 7 is transported to and from the vacuum deposition chamber 2. A heater 22 for heating the evaporation container 7 supplied from the material supplying/replacing system 4 is provided within the vacuum deposition chamber 2.
The present invention aims to provide a technology which uses an apparatus having a simple configuration to efficiently form a film with uniform film thickness and film quality, when continuously forming a film by vacuum deposition of highly reactive lithium. A vacuum deposition system of the present invention has a vacuum deposition chamber wherein an evaporation material is deposited on a substrate by deposition, a substrate supplying/replacing system, connected to the vacuum deposition chamber, for performing supplying and replacing the substrate to and from the vacuum deposition chamber, and a material supplying/replacing system, connected to the vacuum deposition chamber, for performing supplying and replacing the evaporation material to and from the vacuum deposition chamber. The material supplying/replacing system has a material loading chamber in which the evaporation material is disposed inside an evaporation container in an atmosphere blocked off to ambient air and a material replacing chamber where the evaporation container is transported to and from the vacuum deposition chamber. A heater for heating the evaporation container supplied from the material supplying/replacing system is provided within the vacuum deposition chamber.

## Description

### Technical Field

The present invention is related to a technology for manufacturing a lithium secondary battery using a solid electrolyte; and in particular, a technology for forming an anode layer by vacuum deposition.

### Background Art

Conventionally, a lithium ion secondary battery has been widely known as a power source for mobile phones and personal computers.

However, since lithium ion secondary batteries use liquid electrolytes, liquid leakage and fires may occur, which poses a problem regarding their safety.

For this reason, recently, all-solid lithium secondary batteries, which use a solid material as the material for the electrolytes, have been proposed, and are being developed.

In particular, as an all-solid lithium secondary battery using a solid material, an all-solid lithium secondary battery made of a thin film shows promise for use as a power source of card-type electronic components or the like.

In an all-solid lithium secondary battery made of a thin film, an anode consisting of lithium (Li) is formed by vacuum deposition. However, since lithium is a material that is highly reactive to water and air, when an evaporation material consisting of lithium is brought into a deposition chamber, it is necessary to pay sufficient attention to atmosphere of transport pathways.

Furthermore, in a conventional technology, in the case of continuously forming films by vacuum deposition of lithium, the film thickness is controlled by using a shutter mechanism or a film thickness monitor; however, in such a conventional technology, the structural arrangement of the apparatus is complicated; and also, the film thickness or film quality may change as a result of deterioration of lithium due to changes in the lithium over time, changes in the atmosphere, or the like.

As prior art documents related to the present invention, for example, the following document exists.

### [Prior Art Documents]

### [Patent Document]

[Patent Document 1] JP-A 2007-214109

### [Summary of the Invention]

### [Problem to be Solved by the Invention]

The present invention was created in consideration of the above-described problems in the conventional technology, aiming to provide a technology, by use of an apparatus having a simple configuration, which can efficiently form films with uniform film thickness and film quality, when continuously forming films by vacuum deposition of highly reactive lithium.

### [Means for Solving the Problem]

The present invention, which was created to solve the above-described problems, is a vacuum deposition system having a vacuum deposition chamber in which an evaporation material is deposited on a substrate by deposition, a substrate supplying/replacing system, which is connected to the vacuum deposition chamber, for performing supply and replacement of the substrate between the vacuum deposition chamber and the substrate supplying/replacing system, and a material supplying/replacing system, which is connected to the vacuum deposition chamber, for performing supply and replacement of the evaporation material between the vacuum deposition chamber and the material supplying/replacing system, wherein the material supplying/replacing system is provided with a material loading region in which the evaporation material is disposed in an evaporation container in an atmosphere that is blocked from ambient air, and an evaporation container transport region in which the evaporation container is transported to and from the vacuum deposition chamber, and wherein a heating means for heating the evaporation container, supplied from the material supplying/replacing system, is provided within the vacuum deposition chamber.

In the present invention, the material supplying/replacing system is also effective when it has a material loading chamber in which the evaporation material is disposed in the evaporation container in a dry atmosphere that is blocked from ambient air, and a material supplying/replacing chamber which is connected to the material loading chamber and in which supply and replacement of the evaporation material is performed to and from the vacuum deposition chamber in a vacuum.

In the present invention, the heating means is also effective when it is a heater of lamp-heating mechanism.

Further, the present invention is a method of vacuum deposition with the use of one of the above-described vacuum deposition systems, including the steps of disposing a predetermined amount of an evaporation material in the evaporation container in the material loading region, transporting the evaporation container from the material loading region into the inside of the vacuum deposition chamber and supplying the evaporation material, performing vacuum deposition on the substrate by heating the evaporation container within the vacuum deposition chamber, and then ejecting the evaporation container from the vacuum deposition chamber after the completion of the vacuum deposition to return it to the material loading region of the material supplying/replacing system.

In the present invention, it is also effective when the supply and the replacement of the evaporation material is performed with the use of a container transport member, to which a plurality of the evaporation containers can be mounted so as to be capable of being attached and removed at will, to transport the container transport member.

The present invention is most effective when the evaporation material consists of lithium.

In the case of the apparatus of the present invention, it has a substrate supplying/replacing system, which is connected to the vacuum deposition chamber, for performing the supply and the replacement of the substrate between the vacuum deposition chamber and the substrate supplying/replacing system, and a material supplying/replacing system, which is connected to the vacuum deposition chamber, for performing the supply and the replacement of the evaporation material between the vacuum deposition chamber and the material supplying/replacing system; and the material supplying/replacing system is provided with a material loading region in which the evaporation material is disposed in an evaporation container in a dry atmosphere that is blocked off to ambient air, and an evaporation container transport mechanism which transports the evaporation container to and from the vacuum deposition chamber. Consequently, moisture or the like is prevented from attaching to the evaporation material and the evaporation container; and thus, deterioration of the evaporation material can be prevented, when transporting a highly reactive lithium evaporation material into the vacuum deposition chamber, and when returning the evaporation container from the vacuum deposition chamber to the material supplying/replacing system after the completion of deposition.

According to the present invention, a heating means for heating the evaporation container supplied from the material supplying/replacing system is provided within the vacuum deposition chamber; and by heating the evaporation container to apply vacuum deposition on the substrate, the evaporation material can be heated rapidly and the evaporation container can be cooled rapidly after the completion of the deposition.

In the present invention, since the evaporation material can be completely used up during deposition, by setting the amount of evaporation material, for example, to an amount which will completely evaporate in one deposition process, a thin film of a desired film thickness can be formed with an apparatus having a simple configuration, without using a shutter or a film thickness monitor. Further, deterioration of the lithium evaporation material, particularly caused by changes over time or changes in the atmosphere, can be unfailingly prevented.

Further, in the method of the present invention, after deposition using an evaporation container accommodating lithium, for example, the evaporation material can be supplied in a state in which the inside of the vacuum deposition chamber is in a high vacuum, by repeating the step of returning the evaporation container to the material loading region.

In the method of the present invention, if the evaporation material is supplied and replaced with the use of a container transport member to which a plurality of the evaporation containers can be mounted and capable of being attached and removed at will, to transport the container transport member, the efficiency of each step can be greatly increased, since the plurality of evaporation containers can be transported collectively to supply and replace the evaporation material.

### [Effect of the Invention]

According to the present invention, a film with uniform film thickness and film quality can be efficiently formed with the use of an apparatus having a simple structural arrangement, when continuously forming films by vacuum deposition of highly reactive lithium.

### [Brief Explanation of the Drawings]

Fig. 1 is a schematic constitutional front view of an embodiment of the vacuum deposition system according to the present invention.
Fig. 2(a) is a plan view of a tray main body showing an example of a material transport tray used in the embodiment.
Fig. 2(b) is a plan view showing a state in which an evaporation container is mounted to the material transport tray.
Fig. 2(c) is a cross-sectional view along the line A-A of Fig. 2(b).
Fig. 3 is an explanatory diagram (1) showing one example of a deposition process in the embodiment.
Fig. 4 is an explanatory diagram (2) showing one example of a deposition process in the embodiment.
Fig. 5 is an explanatory diagram (3) showing one example of a deposition process in the embodiment.
Fig. 6 is an explanatory diagram (4) showing one example of a deposition process in the embodiment.

### [Explanation of the Reference Numerals]

1... VACUUM DEPOSITION SYSTEM
2... VACUUM DEPOSITION CHAMBER
3... SUBSTRATE SUPPLYING/REPLACING SYSTEM
4... MATERIAL SUPPLYING/REPLACING SYSTEM
6... MATERIAL TRANSPORT TRAY (CONTAINER TRANSPORT MEMBER)
7... EVAPORATION CONTAINER
8... MATERIAL SUPPLY CASSETTE
9... PROTECTIVE LAYER FORMING CHAMBER
10... EVAPORATION MATERIAL
22... HEATER (HEATING MEANS)
31... SUBSTRATE TRANSPORT CHAMBER
32... SUBSTRATE TRANSPORT ROBOT
34... SUBSTRATE LOADING CHAMBER
36... SUBSTRATE REMOVAL CHAMBER
41... FIRST MATERIAL REPLACING CHAMBER
42... SECOND MATERIAL REPLACING CHAMBER
43... MATERIAL REPLACING CHAMBER
44... TRAY TRANSPORT ROBOT
45... MATERIAL LOADING CHAMBER (MATERIAL LOADING REGION)
50... SUBSTRATE

### [Description of the Embodiments]

A preferred embodiment of the present invention will be explained in detail below in reference to the drawings.

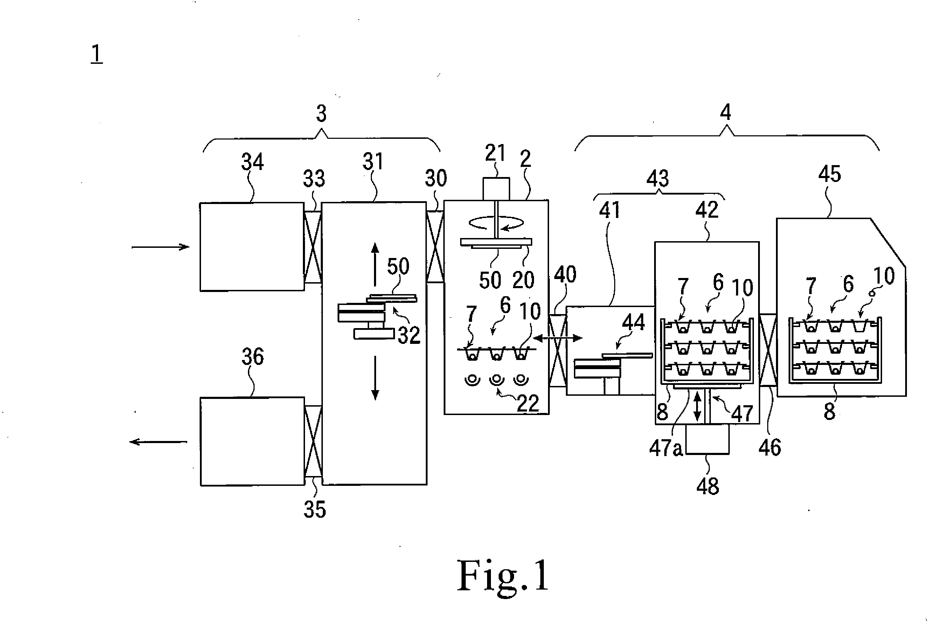

Fig. 1 is a schematic constitutional front view of an embodiment of the vacuum deposition system according to the present invention.

As shown in Fig. 1, a vacuum deposition system 1 used in the present embodiment has a vacuum deposition chamber 2 connected to a vacuum evacuation system, which is not illustrated. The vacuum deposition chamber 2 is constituted so as to introduce, for example, argon (Ar) gas, which is a noble gas.

A substrate holder 20 for holding a substrate 50 is provided in the upper portion within the vacuum deposition chamber 2. The substrate holder 20 is constituted so as to rotate the substrate 50 in a state of being oriented to the horizontal direction by means of, for example, a driving motor 21 disposed in the upper portion of the vacuum deposition chamber 2.

Meanwhile, a heater (heating means) 22 for heating an evaporation material 10 accommodated inside an evaporation container 7, to be explained later, is disposed on a lower portion within the vacuum deposition chamber 2.

In the present invention, although not particularly limited, it is preferable, from the viewpoint of rapidly heating the evaporation material 10 and rapidly cooling the evaporation container 7, to use a heater of lamp-heating mechanism as the heater 22 so that the evaporation container 7, which accommodates the evaporation material 10, is heated indirectly from a predetermined distance, as will be explained below.

In the present embodiment, a substrate supplying/replacing system 3 for performing supply and replacement of the substrate 50 between the vacuum deposition chamber 2 and the substrate supplying/replacing system 3, and a material supplying/replacing system 4 for performing the supply and the replacement of the evaporation material 10 between the vacuum deposition chamber 2 and the material supplying/replacing system 4, are connected to the vacuum deposition chamber 2.

The substrate supplying/replacing system 3 has a substrate transport chamber 31 which is connected to the vacuum deposition chamber 2 via a gate valve 30.

The substrate transport chamber 31 is formed into, for example, a vertically long shape and is connected to the vacuum evacuation system, which is not illustrated. A substrate transport robot 32, which can move up and down with the substrate 50 being placed thereon, is disposed within the substrate transport chamber 31.

In the present embodiment, a substrate loading chamber 34 is connected via a gate valve 33 to, for example, the upper-side portion of the substrate transport chamber 31; and a substrate removal chamber 36 is connected via a gate valve 35 to, for example, the lower-side portion of the substrate transport chamber 31.

The substrate loading chamber 34 and the substrate removal chamber 36 are both connected respectively to the vacuum evacuation system, which is not illustrated.

Meanwhile, the material supplying/replacing system 4 has a material replacing chamber 43 connected to the vacuum deposition chamber 2 via a gate valve 40. The material replacing chamber 43 is connected to the vacuum evacuation system which is not illustrated, and is divided into a first material replacing chamber 41 and a second material replacing chamber 42.

The material replacing chamber 43 is constituted so as to introduce, for example, argon (Ar) gas.

A tray transport robot 44 for supplying/replacing a material transport tray (container transport member) 6 is provided within the first material replacing chamber 41 adjacent to the vacuum deposition chamber 2.

A material loading chamber (material loading region) 45 explained later is connected to the second material replacing chamber 42 via a gate valve 46.

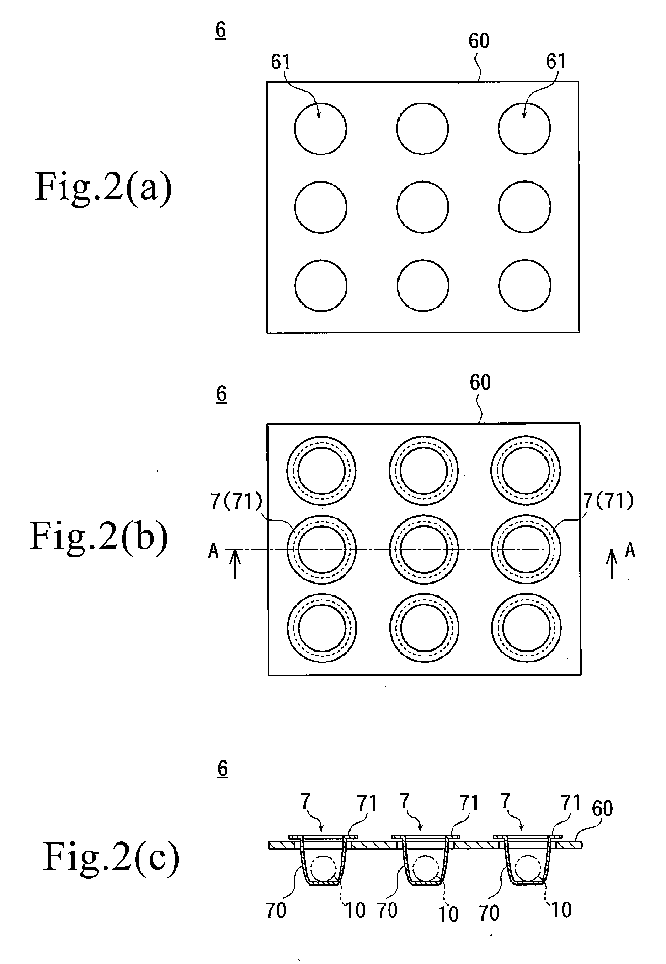

Figs. 2(a) to (c) illustrate an example of the material transport tray used in the present embodiment: Fig. 2(a) is a plan view of the tray main body; Fig. 2(b) is a plan view illustrating a state in which evaporation containers are mounted to the tray main body; and Fig. 2(c) is a cross-sectional view along the line A-A of Fig. 2(b).

As shown in Fig. 2(a), the material transport tray 6 of the present embodiment has a tray main body 60 made of, for example, a flat plate member.

As the material of the tray main body 60, for example, an inorganic material (such as, silica glass), a metal material (such as, stainless steel), a carbon material or the like can be used.

A plurality of mounting holes 61 in the shape of, for example, a circle, for mounting the evaporation containers (boats) 7 are provided on the tray main body 60 so as to penetrate through the tray main body 60.

In the present example, 3 X 3 = nine mounting holes 61 are provided in a matrix on the tray main body 60.

In the present example, the evaporation container 7 made of, for example, a metal material (such as, stainless steel), and has a hull part 70 in an approximately cup-shape (a cylindrical shape with a bottom); and on an edge portion of the opening of the hull part 70, a ring-shaped flange 71 in the shape of, for example, a ring, is provided.

The hull part 70 of the evaporation container 7 has an outer diameter that is slightly smaller than that of the mounting holes 61 of the tray main body 60, and the flange 71 is formed with a slightly larger diameter than that of the mounting holes 61 of the tray main body 60.

Due to such constitution, when the hull parts 70 of the evaporation containers 7 are inserted from above into the mounting holes 61 of the tray main body 60, the flanges 71 of the evaporation containers 7 abut on the surface of the tray main body 60, so that each of the evaporation containers 7 is positioned in a predetermined position.

As shown in Fig. 2(c), the material transport tray 6 of the present embodiment is such that the evaporation materials 10 are inserted to be placed with each of the evaporation containers 7 being mounted to the tray main body 60; and thereby, each of the evaporation materials 10 is transported in a state of being accommodated in each of the evaporation containers 7, along with the tray main body 60.

In the present embodiment, the evaporation materials 10 are supplied to the material transport tray 6 within the above-described material loading chamber 45 (see, Fig. 1).

The material loading chamber 45 is composed of a glove box that can be handled by a human hand.

The dew point temperature within the material loading chamber 45 can be maintained at the extent of -50°C to -60°C; and a dry atmosphere that is blocked off to ambient air can be maintained by introducing, for example, argon (Ar) gas into the material loading chamber 45.

In the material loading chamber 45, the evaporation materials 10 consisting of lithium having a predetermined size and shape (for example, a particle shape) are inserted into the evaporation containers 7 mounted to the tray main body 60 by human hand, for example, one at a time.

In the case of the present invention, the amount of the evaporation material 10 accommodated in each of the evaporation container 7 is not particularly limited, but from the viewpoint of preventing film thickness or film qualities from changing due to changes over time or the like, it is preferable to set it to an amount which can completely evaporate in one deposition step.

The amount of evaporation material 10 accommodated in each of the evaporation container 7 can be appropriately modified, depending on size of the substrate or the positions of the evaporation containers 7 on the tray main body 60 or the like.

A plurality of material transport trays 6, with the evaporation materials 10 being accommodated in each of the evaporation containers 7 are mounted on a material supply cassette 8 and stored within the material loading chamber 45.

If needed, the material supply cassette 8 is transported into the second material replacing chamber 42 by human hand.

A material cassette raising/lowering mechanism 47 for raising and lowering the material supply cassette 8 is provided at a lower part within the second material replacing chamber 42.

The material cassette raising/lowering mechanism 47 has a stage 47a, which is driven in an up-down direction by, for example, a drive motor 48 provided at a lower part of the second material replacing chamber 42; and the material cassette raising/lowering mechanism 47 is configured to raise and lower the stage 47a in a state of, for example, mounting to support one material supply cassette 8.

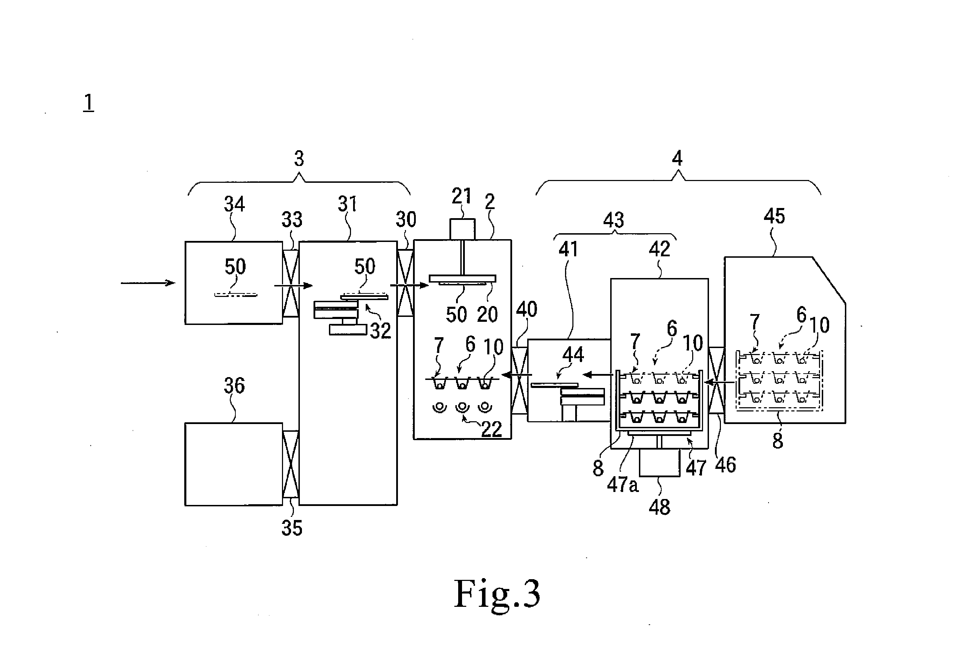

Figs. 3 to 6 are explanatory diagrams illustrating one example of a deposition process in the present embodiment.

As shown in Fig. 3, when carrying out deposition of the evaporation material 10 consisting of lithium on the substrate 50 in the present embodiment, the substrate 50, which has been transported into the substrate transport chamber 31 via the substrate loading chamber 34, is transported into the vacuum deposition chamber 2 by the substrate transport robot 32 to be mounted onto the substrate holder 20.

In the meantime, the material supply cassette 8, with the evaporation materials 10 having been mounted onto the material transport tray 6 in advance, is transported into the second material replacing chamber 42 by human hand. With the use of the tray transport robot 44, one material transport tray 6 at a predetermined position (in this example, the one at the top rank) is transported into the vacuum deposition chamber 2 via the first material replacing chamber 41; and the material transport tray 6 is then positioned at a predetermined film-forming position within the vacuum deposition chamber 2, for example, a position above and separated from the heater 22.

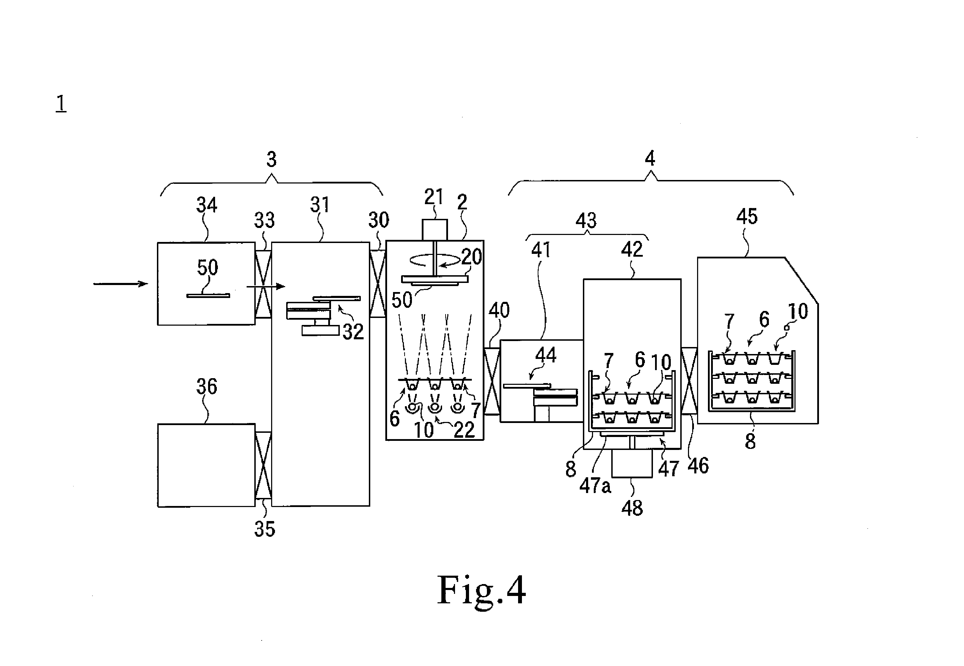

In this state, the pressure within the vacuum deposition chamber 2 is adjusted to a predetermined value; and as shown in Fig. 4, all of the evaporation materials 10 in the evaporation containers 7 are evaporated to form a lithium layer on the substrate 50 by operating the heater 22 to heat the evaporation materials 10 via the evaporation containers 7.

In this process, the deposition is carried out with the drive motor 21 being operated so as to rotate the substrate 50 toward the horizontal direction.

From the viewpoint of performing efficient continuous deposition, for example, as shown in Fig. 4, it is preferable to transport the substrate 50, which is next in line to be subjected to deposition, into the substrate loading chamber 34 in advance during deposition.

Also, from the viewpoint of performing efficient continuous deposition, for example, as shown in Fig. 4, it is preferable to carry out the insertion work of the evaporation materials 10 into the evaporation containers 7 mounted to the tray main body 60 within the material loading chamber 45 as appropriately needed.

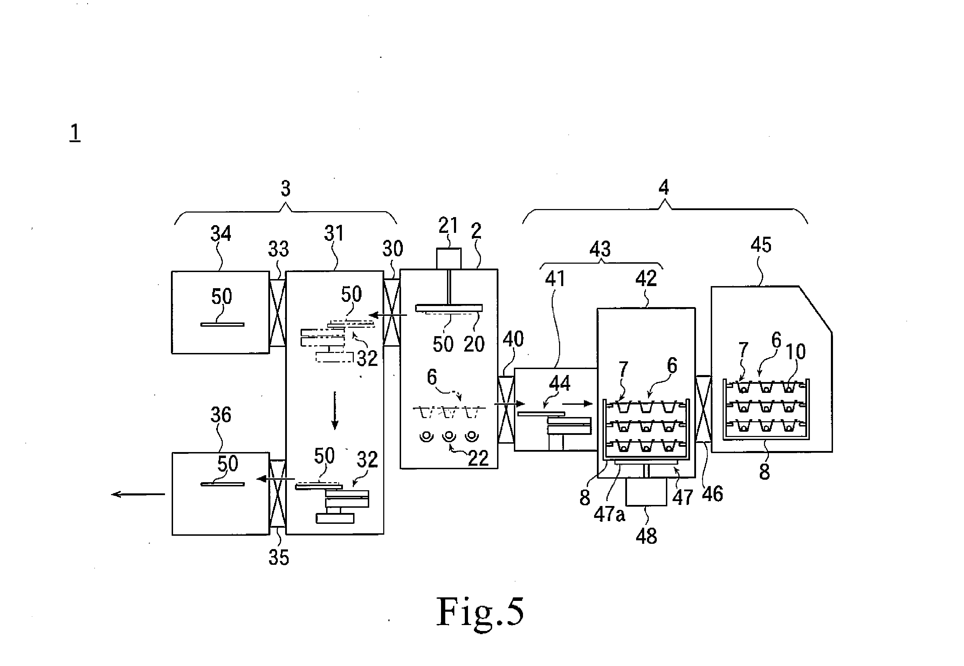

After the completion of the deposition process, as shown in Fig. 5, the substrate 50 which has been detached from the substrate holder 20 is transported into the substrate transport chamber 31 by the substrate transport robot 32.

Further, the substrate transport robot 32 is lowered, in order that the substrate 50 is transported into the substrate removal chamber 36 via a gate valve 35; and then the substrate 50 is discharged from the substrate removal chamber 36 with the use of a substrate transport robot, which is not illustrated.

On the other hand, the material transport tray 6 with all the evaporation materials 10 having been used up is transported from the vacuum deposition chamber 2 into the second material replacing chamber 42 via the first material replacing chamber 41 with the use of the tray transport robot 44, and then mounted at its original position, at the top rank of the material supply cassette 8.

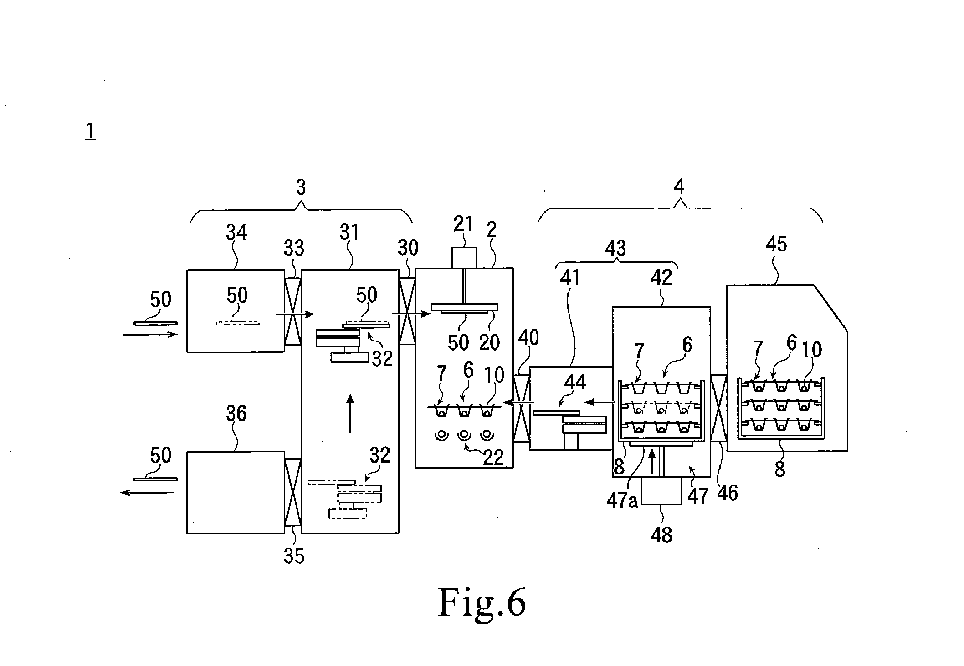

Subsequently, as shown in Fig. 6, the substrate transport robot 32 is raised in the substrate transport chamber 31, in order that the substrate 50 within the substrate loading chamber 34 be transported into the vacuum deposition chamber 2 via the substrate transport robot 32 and then mounted to the substrate holder 20.

In the meantime, the drive motor 48 is operated to raise the cassette raising/lowering mechanism 47 within the second material replacing chamber 42; and then the material transport tray 6 at, for example, the middle rank of the material supply cassette 8 is transported into the vacuum deposition chamber 2 via the first material replacing chamber 41 with use of the tray transport robot 44. This material transport tray 6 is then positioned at a film-forming position within the vacuum deposition chamber 2, for example, a film-forming position above the heater 22.

As explained above, inside the vacuum deposition chamber 2, the heater 22 is operated to heat the evaporation materials 10 via the evaporation containers 7, so that all of the evaporation materials 10 within each of the evaporation containers 7 are evaporated to form a Li layer on the substrate 50.

After the completion of the deposition, the above-described process is repeated. In other words, the substrate 50 upon which deposition has been completed is transported into the substrate removal chamber 36 via the substrate transport chamber 31 with the use of the substrate transport robot 32, and then the substrate 50 is discharged from the substrate removal chamber 36.

Also, the material transport tray 6 to which the deposition has been completed is transported from the vacuum deposition chamber 2 into the second material replacing chamber 42 via the first material replacing chamber 41 with the use of the tray transport robot 44, and then mounted to its original position of the material supply cassette 8.

Afterwards, when all of the evaporation materials 10 on the material transport tray 6 of the material supply cassette 8 within the second material replacing chamber 42 have been used up, the material supply cassette 8 is returned to the material loading chamber 45 by human hand, and a new material supply cassette 8 is transported into the second material replacing chamber 42 by human hand.

Then, the above-described process is repeated.

The evaporation containers 7 as to which a deposition has been completed should be washed with the use of pure water.

The lithium can be efficiently and almost completely removed with the use of pure water.

The present embodiment includes a substrate supplying/replacing system 3, which is connected to the vacuum deposition chamber 2, for performing the supply and the replacement of the substrate 50 between the vacuum deposition chamber 2 and the substrate supplying/replacing system 3, and a material supplying/replacing system 4, which is connected to the vacuum deposition chamber 2, for performing the supply and the replacement of the evaporation material 10 between the vacuum deposition chamber 2 and the material supplying/replacing system 4; and the material supplying/replacing system 4 has a material loading region (material loading chamber 45) in which the evaporation material 10 is disposed in the evaporation container 7 in a dry atmosphere that is blocked off to ambient air, a tray transport robot 44 which transports the evaporation container 7 to and from the vacuum deposition chamber 2, which leads moisture or the like to be prevented from attaching to the evaporation material 10 and the evaporation container 7, and thereby deterioration of the evaporation material 10 can be prevented, when transporting the evaporation material 10, consisting of highly reactive lithium, into the vacuum deposition chamber 2, and when returning the evaporation container 7 from the vacuum deposition chamber 2 to the material supplying/replacing system 4 after the completion of deposition.

Further, according to the present embodiment, a heater 22 for heating the evaporation containers 7 supplied from the material supplying/replacing system 4 is provided within the vacuum deposition chamber 2; and by heating the evaporation containers 7 to perform vacuum deposition on the substrate 50, the evaporation materials 10 can be rapidly heated, and the evaporation containers 7 can be rapidly cooled after the completion of the deposition.

In the case of the present embodiment, since the evaporation material 10 can be completely used up during deposition, a film of a desired film thickness can be formed with the use of an apparatus having a simple configuration without using a shutter or a film thickness monitor, by setting the amount of evaporation material 10, for example, to an amount which will completely evaporate in one deposition step. Further, deterioration of the evaporation material 10 consisting of lithium particularly caused by changes over time or changes in the atmosphere can be reliably prevented.

In addition, as in the present embodiment, after deposition with the use of the evaporation containers 7 accommodating lithium, for example, by repeating the step of returning the evaporation containers 7 to the material loading chamber 45, the evaporation materials 10 can be supplied in a state in which the inside of the vacuum deposition chamber 2 is in a high vacuum.

Meanwhile, in the present embodiment, since the evaporation materials 10 are supplied and replaced by transporting the material transport tray 6, to which a plurality of evaporation containers 7 can be mounted capable of being attached and removed at will, the plurality of evaporation containers 7 can be transported collectively to supply and replace the evaporation materials 10, and the efficiency of each step can be greatly increased.

The present invention is not limited to the above-described embodiment, and various modifications can be made.

For example, in the above-described embodiment, the evaporation containers 7 are mounted to the material transport tray 6 for supplying and replacing the evaporation materials 10, but the present invention is not limited to this embodiment, and, for example, a transport robot or the like can be used to supply and replace a plurality of the evaporation containers 7.

However, from the view point of the efficiency in the deposition process, it is preferable to mount the evaporation containers 7 to the material transport tray 6 for supplying and replacing the evaporation materials 10 as in the above-described embodiment.

Further, the arrangement formation of the chambers in the above-described embodiment is one example, and it can be appropriately modified in accordance with processes as needed. For example, the material supplying/replacing system can also be constituted as one large chamber.

In addition, the present invention can be applied to substrates of various materials, shapes, and sizes (such as, a silicon substrate, a ceramic substrate, a heat-resistant resin substrate, a mica substrate or the like).

Moreover, although the present invention can be applied to materials other than lithium, it is most effective in a technology for manufacturing a lithium secondary battery using lithium in an anode.

## Claims

1. A vacuum deposition system, comprising:
a vacuum deposition chamber in which an evaporation material is deposited on a substrate by deposition;
a substrate supplying/replacing system, which is connected to the vacuum deposition chamber, for performing supply and replacement of the substrate between the vacuum deposition chamber and the substrate supplying/replacing system; and
a material supplying/replacing system, which is connected to the vacuum deposition chamber, for performing supply and replacement of the evaporation material between the vacuum deposition chamber and the material supplying/replacing system,
wherein the material supplying/replacing system includes a material loading region in which the evaporation material is disposed in an evaporation container in an atmosphere that is blocked from ambient air, and an evaporation container transport region in which the evaporation container is transported to and from the vacuum deposition chamber, and
wherein a heating means for heating the evaporation container, supplied from the material supplying/replacing system, is provided within the vacuum deposition chamber.

2. The vacuum deposition system according to claim 1, wherein the material supplying/replacing system has a material loading chamber in which the evaporation material is disposed in the evaporation container in a dry atmosphere that is blocked from ambient air, and a material supplying/replacing chamber which is connected to the material loading chamber and in which supply and replacement of the evaporation material is performed to and from the vacuum deposition chamber in a vacuum.

3. The vacuum deposition system according to claim 1 or 2, wherein the heating means is a heater of lamp-heating mechanism.

4. A vacuum deposition method, with the use of a vacuum deposition system having a vacuum deposition chamber in which an evaporation material is deposited on a substrate by deposition;
a substrate supplying/replacing system, which is connected to the vacuum deposition chamber, for performing the supply and the replacement of the substrate between the vacuum deposition chamber and the substrate supplying/replacing system; and
a material supplying/replacing system, which is connected to the vacuum deposition chamber, for performing supply and replacement of the evaporation material between the vacuum deposition chamber and the material supplying/replacing system,
wherein the material supplying/replacing system is provided with a material loading region in which the evaporation material is disposed in an evaporation container in an atmosphere that is blocked from ambient air, and an evaporation container transport region in which the evaporation container is transported to and from the vacuum deposition chamber, and
wherein a heating means for heating the evaporation container, supplied from the material supplying/replacing system, is provided within the vacuum deposition chamber,
the method, comprising the steps of:
disposing a predetermined amount of the evaporation material inside the evaporation container in the material loading region;
transporting the evaporation container from the material loading region into the vacuum deposition chamber to supply the evaporation material;
performing vacuum deposition on the substrate by heating the evaporation container in the vacuum deposition chamber; and
ejecting the evaporation container from the vacuum deposition chamber after completion of the vacuum deposition to return it to the material loading region of the material supplying/replacing system.

5. The vacuum deposition method according to claim 4, wherein the supply and the replacement of the evaporation material is performed by using a container transport member, to which a plurality of the evaporation containers can be mounted so as to be capable of being attached and removed at will, to transport the container transport member.

6. The vacuum deposition method according to claim 4 or 5, wherein the evaporation material consists of lithium.
